# EUROPEAN PATENT SPECIFICATION

(11) **EP 3 314 123 B1**
(45) Date of publication and mention of the grant of the patent: **03.04.2024**
(21) Application number: 16815271.8
(22) Date of filing: 23.06.2016
(51) Int. Cl.: F04B 11/00, F04B 43/00, F04B 43/12, F04B 43/04, G01N 15/14, G01N 15/10, B01L 3/00

(54) **SYSTEMS, APPARATUSES, AND METHODS FOR CELL SORTING AND FLOW CYTOMETRY**
SYSTEME, VORRICHTUNGEN UND VERFAHREN ZUR ZELLSORTIERUNG UND DURCHFLUSSZYTOMETRIE
SYSTÈMES, APPAREILS ET PROCÉDÉS DE TRI DE CELLULES ET CYTOMÉTRIE DE FLUX

(30) Priority: 23.06.2015 US 201562183640 P
(43) Date of publication of application: 02.05.2018
(60) Divisional application: 24157131.4
(73) Proprietor: NanoCellect Biomedical, Inc., San Diego, CA 92121 (US)
(72) Inventor: MORACHIS, Jose M., San Diego, California 92121 (US); CHO, Sung Hwan, San Diego, California 92121 (US); MEI, Zhe, San Diego, California 92121 (US); POONKA, Phillip, San Diego, California 92121 (US); ARDILA, Constance, San Diego, California 92121 (US); NAREZ, Gerardo, San Diego, California 92121 (US); ALAYNICK, William, San Diego, California 92121 (US)
(74) Representative: Avidity IP
(86) International application number: PCT/US2016/038937
(87) International publication number: WO 2016/210077

(56) References cited:
- US-A1- 2011 196 303
- US-A1- 2011 229 872
- US-A1- 2011 229 872
- US-B2- 7 258 774
- US-B2- 7 258 774
- US-B2- 8 268 177
- US-B2- 8 268 177
- US-B2- 8 277 764
- US-B2- 8 277 764
- US-B2- 8 715 573
- US-B2- 8 715 573

## Description

### BACKGROUND

Fluorescence-activated cell sorting (FACS) and flow cytometry instruments usually utilize pumps to flow biological samples or particles suspended in a solution through the instrument. A second stream of sheath fluid (typically phosphate-buffered saline) is commonly used for hydrodynamic focusing of the sample stream. Because cell sorting can be sensitive to timing, and cell transit time is dependent on flow rate, it is desirable for the flow rates of these fluidic systems to be stable to achieve satisfactory sorting performance.

Traditional FACS instruments rely on expensive and sophisticated high-pressure driven pump systems to force the sample and sheath fluids through a cuvette or nozzle. These pressure-driven pumps are usually very sensitive, bulky, expensive, and do not provide the ability to calculate the concentration of cells being analyzed. Another problem with traditional pressure-driven pumps in FACS systems is that the fluidic components can be too expensive to replace for every experiment and extensive cleaning is usually needed. This results in contamination risks and/or wasted time cleaning and flushing the instruments in between runs.

Similar problems make it difficult to use other pump systems in FACS instruments. For example, a sophisticated pressure-driven pump system with flow rate feedback may not be used in an example FACS system because the samples would make contact with and contaminate the flow rate sensors, which are usually expensive and not disposable. Syringe pumps can be one alternative, as all of the components in syringe pumps can be readily disposed of. However, a problem with syringe pumps is that usage is typically complex and user-intensive, since the user may need to fasten a Luer connection onto a syringe, fasten the syringe to the pump, adjust the pump plunger, and/or the like.
US 8,366,667 B2 discloses a medical fluid infusion system including: a fluid pathway for transporting a pulsatile flow of fluid; a dampening element in communication with the fluid pathway, the dampening element configured to actively dampen pressure fluctuations of the pulsatile flow to smoothen the pulsatile fluid flow, the dampening element operable in any orientation; and a fluid flow sensor disposed along the fluid pathway downstream of the dampening element to measure the flow rate of the smoothened fluid flow.
US 7,258,774 B2 discloses a microfluidic device comprises pumps, valves, and fluid oscillation dampers. In a device employed for sorting, an entity is flowed by the pump along a flow channel through a detection region to a junction.
US 8,277,764 B2 discloses a single disposable cartridge for performing a process on a particle, such as particle sorting, encapsulates all fluid contact surfaces in the cartridge for use with microfluidic particle processing technology.
US 2011/0229872 A1 discloses a microfabricated device for sorting cells based on a desired characteristic, for example, reporter-labeled cells can be sorted by the presence or level of reporter on the cells.
US 8,715,573 B2 discloses a fluidic system that includes a sheath pump to pump sheath fluid from a sheath container through a sample port into an interrogation zone and a waste pump to pump the sheath fluid and a sample fluid as waste fluid from the interrogation zone into a waste container, and a processor to calculate a time window based on the flow rate of the sample fluid.

### SUMMARY

The invention provides a system (600), comprising:
a microfluidic channel in fluid communication with a sorting chamber (710), a sheath fluid channel (610), and a sample fluid channel (720);a sample fluid pump (525) in fluid communication with the sample fluid channel (720), the sample fluid pump (525) configured to pump sample fluid through the sample fluid channel (720) to the sorting chamber (710) at a sample fluid flow rate;
a sheath peristaltic pump (535) in fluid communication with the sheath fluid channel (610), the sheath peristaltic pump (535) configured to pump a fluid through the sheath fluid channel (610) at a sheath fluid flow rate; and
a sheath fluid damper (620) including a gas and in fluid communication with the sheath fluid channel (610), the sheath fluid damper (620) configured to reduce variations in the sheath fluid flow rate by compression and expansion of the gas in response to fluid flow in the sheath fluid channel (610).
In some embodiments, a disposable cartridge for a cell sorting system includes a substrate. The disposable cartridge also includes a sorting chamber fabricated in the substrate. A fluid channel is fabricated in the substrate and in fluid communication with the sorting chamber to convey fluid from a fluid inlet to the sorting chamber. The disposable cartridge further includes a fluid bubble damper fabricated in the substrate and in fluid communication with the fluid channel to reduce variations in a flow rate of the fluid from the fluid inlet to the sorting chamber via the fluid channel.

In some embodiments, a method of priming a microfluidic chip is disclosed. The microfluidic chip includes an inlet in fluid communication with a sorting chamber via a microfluidic channel. The method includes introducing degassed liquid into the sorting chamber via the inlet and the microfluidic channel. The degassed liquid absorbs gas trapped in the sorting chamber.

It should be appreciated that all combinations of the foregoing concepts and additional concepts discussed in greater detail below (provided such concepts are not mutually inconsistent) are contemplated as being part of the inventive subject matter disclosed herein. The scope of protection is defined by the respective subject-matter of the appended patent claims.

### BRIEF DESCRIPTION OF THE DRAWINGS

The skilled artisan will understand that the drawings primarily are for illustrative purposes and are not intended to limit the scope of the inventive subject matter described herein. The drawings are not necessarily to scale; in some instances, various aspects of the inventive subject matter disclosed herein may be shown exaggerated or enlarged in the drawings to facilitate an understanding of different features. In the drawings, like reference characters generally refer to like features (e.g., functionally similar and/or structurally similar elements).
FIG. 1 illustrates a schematic of a cell sorting system using peristaltic pumps to pump sample fluid and sheath fluid.
FIG. 2 illustrates a schematic of a cell sorting system that includes dampers, according to embodiments.
FIG. 3A illustrates schematics of air dampers that can be used in the cell sorting system shown in FIG. 2, according to embodiments.
FIG. 3B illustrates flow rates of systems using air dampers shown in FIG. 3A, according to embodiments.
FIG. 4A illustrates a schematic of external gas dampers coupled to fluid channels for cell sorting systems, according to embodiments.
FIG. 4B illustrates an example system using external air dampers, according to embodiments.
FIG. 5 illustrates integrated gas dampers for peristaltic pumps that pump sample and sheath fluid to a microfluidic cell sorting system, according to embodiments.
FIG. 6A illustrates a cell sorting cartridge including a gas damper for peristaltic pumps, according to embodiments.
FIG. 6B illustrates a cell sorting cartridge including a gas damper for peristaltic pumps, according to embodiments.
FIG. 7 illustrates a cell sorting cartridge with on-cartridge bubble dampers for both sample fluid channel and sheath fluid channel, according to embodiments.
FIG. 8A illustrates a cell sorter and a closed-path microfluidic cell sorter chip that can use peristaltic pumps and gas dampers, according to embodiments.
FIG. 8B illustrates a system including a detection and sorting chip that can use peristaltic pumps and gas dampers, according to embodiments.
FIG. 9 is a plot that shows flow rates versus time with and without gas dampers, according to embodiments.
FIGS. 10A and 10B are plots of flow rate versus time with external gas dampers for sample fluid and sheath fluid, respectively, according to embodiments.
FIGS. 11A-11B are plots of flow rate versus time with and without an on-cartridge damper for sheath fluid, according to embodiments.
FIGS. 12A-12B are plots of flow rate versus time with and without an on-cartridge damper for sample fluid, according to embodiments.
FIG. 13A illustrates a microfluidic cell detector and sorter, according to an embodiment.
FIG. 13B is a plot that illustrates sorting using a peristaltic pump with an on-cartridge bubble damper, according to embodiments.
FIG. 14 illustrates an example cell sorter chip, according to embodiments.
FIGS. 15A-15B illustrate priming the cell sorter chip of FIG. 14 with a regular buffer, according to embodiments.
FIGS. 15C-15D illustrate priming the cell sorter chip of FIG. 14 with a degassed buffer, according to embodiments.
FIG. 16 is a flow chart illustrating an auto-sort calibration process, according to embodiments.
FIGS. 17A-17B illustrate optimization of particle sorting positioning and timing, according to embodiments.

### DETAILED DESCRIPTION

Embodiments disclosed herein relate generally to systems, apparatuses, and methods for flow cytometry and fluorescent activated cell sorting and, in some embodiments, to systems, apparatuses, and methods that encompass microfluidics-based flow cytometry and fluorescent activated cell sorting (FACS), optionally in combination with one or more subassemblies disclosed therein.

Traditional cell sorters like the FACS Aria (BD) use pressure pumps with complicated fluidic lines not meant to be disposable for every experiment. Users of traditional cell sorters usually perform rigorous washing steps in between experiments to avoid cross contamination. Microfluidic based cell sorters like the Tyto Cell Sorter (Miltenyi Biotec) or the On-chip Sort (On-chip Biotechnologies) use pressure or syringe pumps to have a consistent flow rate for sorting; however, these pumps are more expensive.

In some embodiments, use of a peristaltic pump for pumping fluid into disposable microfluidic flow cells and fluidics as disclosed herein can simplify cleaning and reduce the possibility of cross-contamination. Peristaltic pumps are affordable and can allow for ease of replacement of any fluidic line(s) that interact with the sample fluid. Further, peristaltic pumps can be relatively more compact than existing pressure pumps, making them suitable for relatively inexpensive instruments that are within the budgets of most labs.

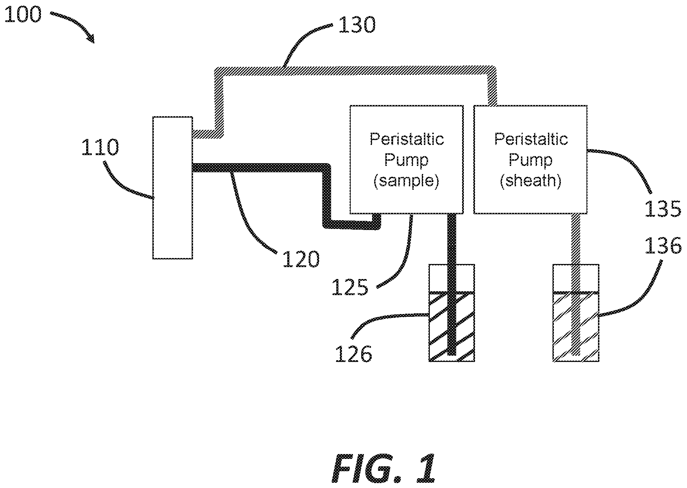

FIG. 1 illustrates a cell sorting system 100, according to embodiments. The system 100 includes a sorting chamber 110 (also sometimes referred to as sorting chip or cartridge) in fluid communication with a sample fluid channel 120 and a sheath fluid channel 130. The system 100 also includes a peristaltic pump 125 configured to pump sample fluid from a sample fluid source 126 to the sorting chamber 110 via the sample fluid channel 120. The system also includes a peristaltic pump 135 configured to pump sheath fluid from a sheath fluid source 136 to the sorting chamber 110 via the sheath fluid channel 130.

Peristaltic pumps can sometimes produce large flow pulsations (also sometimes referred to as variations of flow rates) that may affect analysis and sorting performance in flow cytometers and FACS systems. Bench-top flow cytometers (but not sorters) such as the BD Accuri^{™} C6 from BD Biosciences or the Xitogen flow cytometer use peristaltic pumps together with various combinations of dampers and pump controls. This can provide an advantage in cost savings, easier interface, and less maintenance. Example flow cytometers with peristaltic pumps are disclosed in PCT Application No. WO 2013/181453 A2.

Some embodiments disclosed herein are directed to peristaltic pumps with disposable fluidic components for use in cell sorting and/or microfluidic based fluorescence activated cell sorting (FACS). Some embodiments disclosed herein are directed to fluidic systems that use peristaltic pumps to drive sheath fluid and/or sample fluid. In such systems, sample and shear fluids are delivered into the microfluidic cell sorting cartridge at consistent flow rates to achieve high particle sorting and/or analysis performance. The consistent flow rates are achieved using fluid dampers, which can be either coupled to fluid channels that deliver the sheath and sample fluid (also referred to as external dampers) or integrated into the sorting cartridge (also referred to as integrated dampers or on-cartridge dampers). In some embodiments, the fluid dampers can be filled with gas, such as air, noble gases, or any other gas that is appropriate. In some embodiments, the fluid dampers can be filled with immiscible compressible fluid such as water gas, which is usually produced from synthesis gas and composed of carbon monoxide and hydrogen.

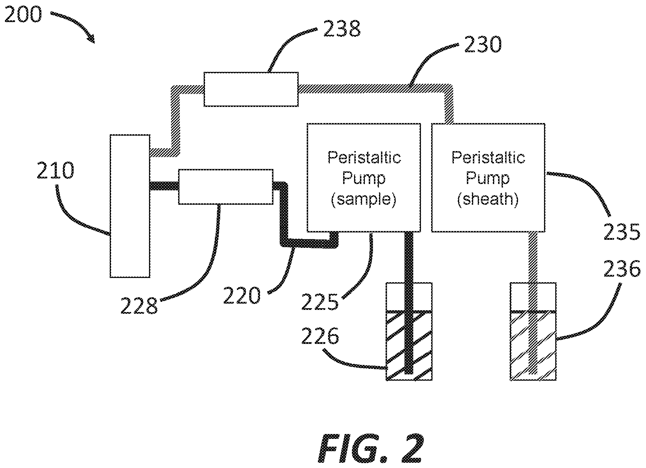

FIG. 2 shows a schematic of a schematic of a cell sorting system 200 that includes one or more dampers to reduce flow rate variations of peristaltic pumps, according to embodiments. The system 200 includes a sorting chamber 210 configured to receive a first fluid from a first fluid channel 220 (also sometimes referred to a "sample fluid channel") and to receive second fluid (e.g., a sheath fluid) from a second fluid channel 230 (also sometimes referred to a "sheath fluid channel"). A peristaltic pump 225 pumps the first fluid from a first fluid source 226 to the sorting chamber via the first fluid channel 220. A first damper 228 is coupled to the first fluid channel 220 to reduce the variations of the flow rate in the first channel 220 so as to deliver a consistent flow to the sorting chamber 210. Similarly, another peristaltic pump 235 is configured to pump the second fluid from a second fluid source 236 to the sorting chamber via the second fluid channel 230, and a second damper 238 is coupled to the second fluid channel 230 to reduce the variations of the flow rate in the second channel 230.

In operation, the dampers 228 and 238 in the first fluid channel 220 and the second fluid channel, respectively, can be filled with gas. In some embodiments, prior to cell sorting, the entire system 200 can be flushed with gas. A fluid can then be pumped through the system 200 to trap some gas within the dampers 228 and 238 and push out excess gas. When the first fluid is flowing in the first channel 220, the first fluid can enter the first damper 228 and compress the gas in the first damper 228. In other words, a portion of the gas in the first damper 228 can be trapped in the damper 228 that forms a cul-de-sac. In this manner, the first damper 228 can slow the flow of the first fluid in the first fluid channel 220. As the volumetric flow rate of the fluid leaving the peristaltic pump 225 can fluctuate periodically, the fluid volume in the first damper 228 can fluctuate proportionately as the gas is compressed or expanded due to changes in liquid pressure, which dampens the perturbations in flow rate. The second damper 238 can function in similar ways as the first damper 228 as described above.

In this manner, the dampers 228 and 238 can act as a mechanical low-pass filter that can reduce the dynamic range of flow rates (or the range of fluctuations in the flow rates, or the variation in flow rates, and/or the like). This reduction in flow rate range can narrow the distribution of cell/particle velocities since the cells/particles are typically flowing at the same rate as the sample fluid. As a result, the time delay between cell detection and cell sorting can be derived more reliably, thereby improving the sorting performance. In some embodiments, the decreased pulsation can result in more confined hydrodynamic focusing of the sample fluid stream, which in turn can lead to higher coefficient of variation (CV) values in the fluorescent signals in the detection system.

Various types of gases can be filled in the dampers 228 and 238. In one example, the dampers 228 and 238 can be filled with atmospheric air. In another example, the dampers 228 and 238 can be filled with one or more gases that are not prone to react with the sample fluid and/or the sheath fluid, such as, for example, noble gases (e.g., Helium, Neon, Argon, Xenon, and/or combinations thereof). The initial pressure of the gas in the dampers 228 and 238 can be, for example, about 0.1 atmosphere, 0.2 atmosphere, 0.5 atmosphere, 0.8 atmosphere, 1 atmosphere, 1.2 atmosphere, 1.5 atmosphere, or any other pressure that is appropriate, including all values and sub ranges in between.

In some embodiments, at least one of the dampers 228 and 238 can be open to respective fluid channel (220 or 230) such that sample and sheath fluids can freely enter the dampers 228 and 238. In some embodiments, at least one of the dampers 228 and 238 can be separated from the corresponding channel 220 or 230 by a separator. The separator can include flexible or pliable membranes that readily allow expansion and contraction of the volume within the dampers 228 and 238 without leaking any gas within the dampers 228 and 238.

In some embodiments, one or more of the dampers 228 and 238 can be made of disposable materials. In some embodiments, the dampers 228 and 238 can include silicone and/or fiber-glass reinforced silicone. In some embodiments, the dampers 228 can 238 can be made of acryl (also referred to as the acryloyl group, prop-2-enoyl, or acrylyl). In some embodiments, the dampers 228 and 238 can include polydimethylsiloxane (PDMS). In yet another example, the dampers 228 and 238 can include poly(methyl methacrylate )(PMMA). PMMA is usually transparent to visible light and has low-fluorescence, thereby facilitating optical detection and sorting of cells, as well as microscopic imaging of the cells. In some embodiments, the tubing in the first channel 220 and the second channel 230 can also be made of the disposable materials.

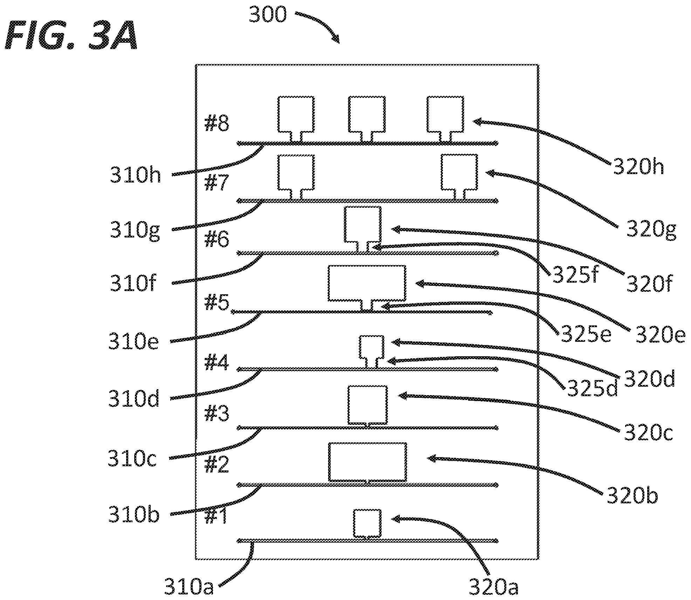

FIG. 3A shows schematics of example dampers (collectively denoted by the reference character 300) that can be used to reduce flow rate variations in flow cytometers using peristaltic pumps as described herein. The dampers 300 include eight example, non-limiting configurations, numbered #1-#8. The first configuration #1 includes a fluid channel 310a (e.g., similar to the sample fluid channel or the sheath fluid channel) and a gas chamber 320a coupled to the fluid channel 310a to function as a damper. The gas chamber 320a has a substantially square shape. In an example embodiment, the volume of the gas chamber 320a can be about 92 mm³. The second configuration #2 includes a fluid channel 310b and a gas chamber 320b coupled to the fluid channel 310b. The gas chamber 320b has a rectangular shape. In an example embodiment, the gas chamber 320b has a volume of about 369 mm³. The third configuration #3 includes a fluid channel 310c and a gas chamber 320c coupled to the fluid channel 310c having a square shape. In an example embodiment, the gas chamber 320s has a volume of about 184 mm³. For these three configurations #1 to #3, the gas chambers 320a to 320c are almost directly coupled to the fluid channels 310a to 310c, respectively. In other words, the sizes and/or volumes of the connectors between the gas chambers 320a to 320c and the corresponding fluid channels 310a to 310c can be negligible.

The fourth to sixth configurations #4 to #6 shown in FIG. 3A include gas chambers having different shapes. The fourth configuration #4 includes a fluid channel 310d and a gas chamber 320d coupled to the fluid channel 310d. The major part of the gas chamber 320d has a square shape but the gas chamber 320d also includes a neck portion 325d connecting the major part of the gas chamber 320d with the fluid channel 310d. In an example embodiment, the gas chamber 320d has a volume of 92 mm³, which can be the same as the volume of the gas chamber 310a, but the neck portion 325d has a non-negligible volume. Similarly, the fifth configuration #5 includes a fluid channel 310e and a gas chamber 320e coupled to the fluid channel 310e. The gas chamber 320e includes a neck portion 325e to connect the major portion of the gas chamber 320e with the fluid channel 310e. In an example embodiment, the gas chamber 320e has a volume of about 369 mm³. The sixth configuration #6 includes a fluid channel 310f and a gas chamber 320f coupled to the fluid channel 310f. The gas chamber 320f includes a neck portion 325f to connect the major portion of the gas chamber 320f with the fluid channel 310f. In an example embodiment, the gas chamber 320f has a volume of about 184 mm³.

The seventh configuration #7 includes a fluid channel 310g and two gas chambers 320g coupled to the fluid channel 310g in series. In an example embodiment, the total volume of the two gas chambers 320g is about 368 mm³. In one embodiment, each gas chamber of the two gas chambers 320g functions as a damper. In another embodiment, the two gas chambers 320g collectively function as a damper. The eighth configuration #8 includes a fluid channel 310h and three gas chambers 320h coupled to the fluid channel 310h in series. The total volume of the three gas chambers 320h is about 552 mm³. The gas chambers 320g and 320h are disposed on the same side of the corresponding fluid channel 310g and 310h for illustrative purposes. In practice, the gas chambers can be disposed symmetrically or asymmetrically on both sides of the fluid channels. In addition, the number of gas chambers can also be greater than three (e.g., 5 gas chambers, 8 gas chambers, 10 gas chambers, or more).

The volume of the gas chambers 320a to 320h, in practice, can be different from the volumes shown in FIG. 3A. For example, the volume of the gas chambers 320a to 320h can be about 60 mm³ to about 600 mm³ (e.g., about 60 mm³, about 80 mm³, about 100 mm³, about 120 mm³, about 150 mm³, about 180 mm³, about 200 mm³, about 240 mm³, about 280 mm³, about 300 mm³, about 350 mm³, about 400 mm³, about 450 mm³, about 500 mm³, about 550 mm³, and about 600 mm³, including all values and sub ranges in between).

The two dimensional (2D) cross sections of the gas chambers 320a to 320h shown in FIG. 3A have a rectangular (or square) shape for illustrative purposes. Any suitable shape of the dampers 320a-320h can be employed depending on, for example, constraints of space in the resulting flow cytometer and/or desired form factor of the sorting cartridge. For example, the 2D cross sections of gas chambers 320a to 320h can be oval, round, polygonal, or any other shape known in the art. In the three dimensional (3D) space, the gas chambers 320a to 320h can be, for example, cylindrical, cuboid, spherical, or any other suitable shape known in the art.

As described herein, the gas chambers 320a to 320h can reduce flow rate variations of the fluid propagating in the corresponding fluid channels 310a to 310h. In some embodiments, the performance of the gas chambers 320a to 320h can be characterized by the flow rate variation after using the gas chambers 320a to 320h. For example, the variations of the flow rates can be less than 10% of the average flow rate (e.g., about 10%, about 8%, about 5%, about 3%, about 2%, about 1%, or less than 1%, including all values and sub ranges in between). The average flow rate that can be implemented in the system 300 can be, for example, about 1 µl/min to about 10 ml/min (e.g., 1 µl/min, 5 µl/min, 10 µl/min, 20 µl/min, 30 µl/min, 50 µl/min, 75 µl/min, 100 µl/min, 150 µl/min, 200 µl/min, 250 µl/min, 300 µl/min, 400 µl/min, 500 µl/min, 600 µl/min, 700 µl/min, 800 µl/min, 900 µl/min, 1 ml/min, 2 ml/min, 3 ml/min, 5 ml/min, 7.5 ml/min, or 10 ml/min, including all values and sub ranges in between).

Another parameter that can also characterize the performance of the gas chambers 320a to 320h is the reduction of flow rate variations induced by the use of the gas chambers 320a to 320h. The gas chambers 320a to 320h can be configured to reduce the variations of the flow rates by more than 80% compared to variations of flow rates without any gas chambers (e.g., more than 80%, more than 85%, more than 90%, more than 92.5%, more than 95%, more than 97.5%, more than 98%, more than 99%, or more than 99.5%, including all values and sub ranges in between). For example, flow rates after peristaltic pumps can be anywhere between 0 and 200 µl/min, i.e. the variation of the flow rates is about 200 µl/min. After using the gas chambers 320a to 320h, the flow rates can be about 110 µl/min to about 115 µl/min, i.e. the variation of the flow rates is about 5 µl/min, corresponding to a reduction of 97.5%.

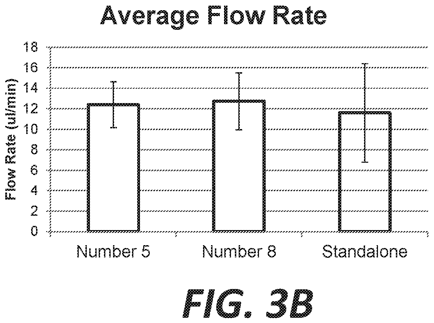

FIG. 3B illustrates measured flow rates in the fifth ("Number 5") and eighth ("Number 8") configurations shown in FIG. 3A. For comparison, flow rates in a system without dampers are also included in FIG. 3B ("Standalone"). It can be seen that the three systems have similar average flow rates of about 12 µl/min, but the fifth configuration has the most stable performance (i.e., the least amount of flow variations as indicated by the error bar). In some embodiments, larger damper volume can lead to better performance as the damper volume determines, at least in part, the amount of trapped gas that can be compressed and expanded for pulsation dampening. The fifth configuration also demonstrates robust performance under a wide range of flow rates (for example between 1 µl/min to 1 ml/min).

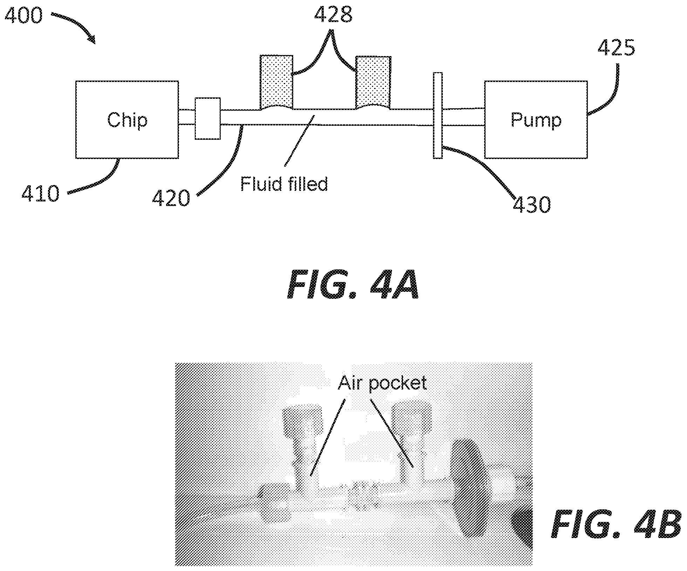

FIG. 4A illustrates a system 400 using external dampers to regulate flow rates after peristaltic pumps, according to embodiments. The system 400 includes a target chip 410 that receives fluid (e.g., sample fluid and/or sheath fluid) delivered by a fluid channel 420. The target chip 410 can be a sorting chamber, a detection chamber, and/or any other device(s) that receive fluid at constant flow rates. A peristaltic pump 425 pumps the fluid toward the target chip 410 via two chambers 428. The fluid channel 420 can also include an optional in-line filter 430 for sterilizing or clarifying culture media.

FIG. 4B illustrates an example system schematically shown in FIG. 4A. In this example, the dampers 428 can be constructed using fluidic fittings (e.g., Nordson Medical, Fort Collins, CO). More specifically, the male end of a Male Luer to Female Luer Thread Style Coupler (LC78-1) can be connected to the vertical segment of a female Luer lug style tee (e.g., FTLT-1). The female end of the same Male Luer to Female Luer Thread Style Coupler can be capped with a Male Luer Integral Lock Ring Plug (e.g., LP4-1) so as to create a chamber that can trap gases. A second identical fitting assembly can also be constructed to produce a second gas chamber. A Male Luer Slip Coupler (e.g., MTLCS-1) can be used to connect the two assemblies with the capped vertical segments both facing upward. A 0.2 µm Acrodisc Syringe Filter (e.g., 4612, PALL Life Sciences, Port Washington, NY) can be connected to one end of the combined assembly. Two Male Luer Integral Lock Ring to 500 Series Barb (1/16") fittings (MTLL004-1) can be connected to both free ends of the resulting assembly. External dampers 428 without the filter 420 can be used for sample fluid. An inlet silicone tubing can be connected to the barb on the filter end of the air damper 428, while an outlet silicone tubing can be connected to the barb on the outlet end of the air damper 428.

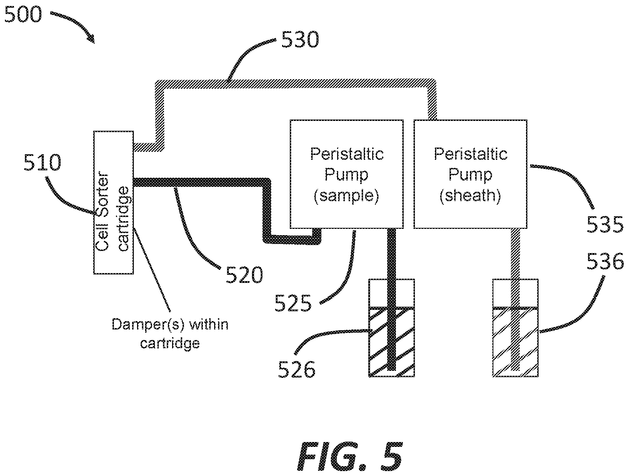

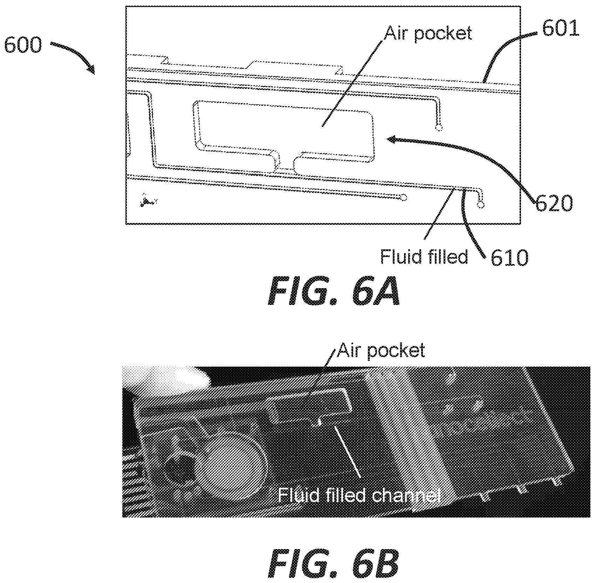

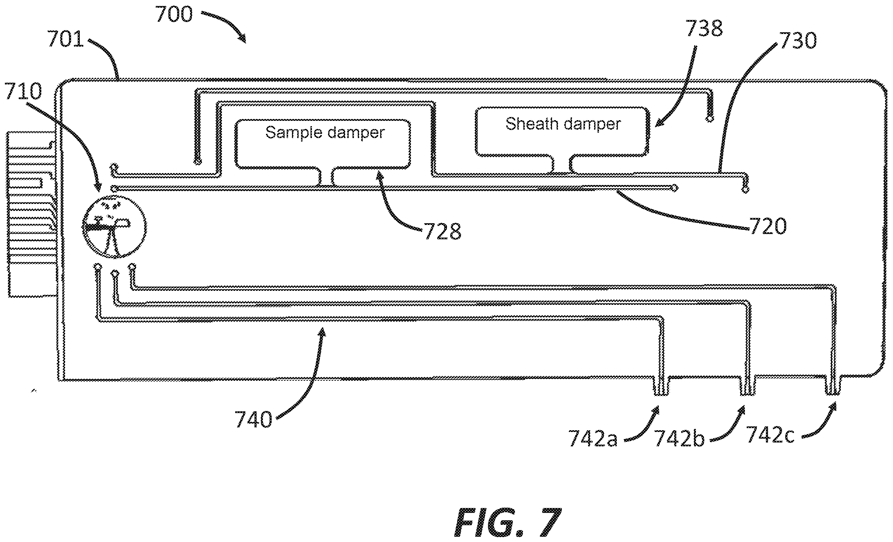

FIG. 5 illustrates a system 500 using one or more on-cartridge dampers to regulate flow rates of fluid delivered by peristaltic pumps. The system 500 includes a cartridge 510 configured to receive sample fluid from a sample channel 520 and to receive sheath fluid from a sheath channel 530. A peristaltic pump 525 in the sample channel 520 pumps the sample fluid from a sample fluid source 526 toward the cartridge 510 and another peristaltic pump 535 in the sheath channel 530 pumps the sheath fluid from a sheath fluid source 536 toward the cartridge 510. The system 500 shown in FIG. 5 is different from the system 100 shown in FIG. 1 in that the cartridge 510 includes integrated dampers (see, e.g., FIG.6A, FIG. 6B, or FIG. 7) to regulate flow rates of the sample and sheath fluid.

FIG. 6A illustrates a system 600, and illustrates how empty space in an existing substrate design can be modified to construct/include gas dampers. The system 600 includes a substrate 601, in which empty space is fabricated to construct a fluid channel 610 and a gas chamber 620 ("air pocket") in fluid communication with the fluid channel 610. The substrate 601 can be made of low-cost and disposable materials such as silicone, fiber-glass reinforced silicone, acryl, PDMS, PMMA, or any other material known in the art. In one example, the gas chamber 620 can be molded in the cartridge 610 along the fluidic channel 610. In another example, the gas chamber 620 can be fabricated by etching the substrate 601. The parameters of the gas chamber 620 (e.g., volume, reduction of flow rate variations, etc.) can be substantially similar to the gas chambers 320a to 320h shown in FIG. 3A and described above.

FIG. 6B is a photo of an example cell sorting cartridge including integrated dampers schematically shown in FIG. 6A. Using integrated dampers (also referred to as on-cartridge dampers) can reduce the size and cost of the damper, by utilizing empty space in the chip cartridge rather than fabricating additional external gas dampers. The working principle of the integrated on-cartridge gas damper can be identical to the external dampers described above: gas is trapped in a pocket above the fluid channel and compresses to dampen flow rate pulsations.

FIG. 7 illustrates an example flow cytometer 700 using on-chip dampers to regulate flow rates of fluids, such as, for example, sample and sheath fluids. The cytometer 700 includes a substrate 701, in which a sorting chamber 710 is fabricated. The sorting chamber 710 receives sample fluid, including cells to be sorted, from a sample channel 720 and receives sheath fluid from a sheath channel 730. The sample channel 720 includes a sample fluid damper 728 in fluid communication with the sample fluid channel 720. The sheath channel 730 similarly includes a sheath fluid damper 738 in fluid communication with the sheath fluid channel 730. The two dampers 728 and 738 (also referred to as bubble dampers) include empty spaces defined by the substrate 701 and therefore are intergrade into the substrate 701 with high compactness. After sorting, different types of cells in the sample fluid are directed into three different output ports 742a, 742b, and 742c in an output channel 740. In practice, the number of output ports (also the number of different types of cells that can be distinguished by the sorting system 700) can be greater or less than three. The system 700 shown in FIG. 7 is fabricated in a single chip and therefore can be highly compact. In addition, the substrate 701 can be made of low-cost and disposable materials, thereby avoiding extensive cleaning between runs.

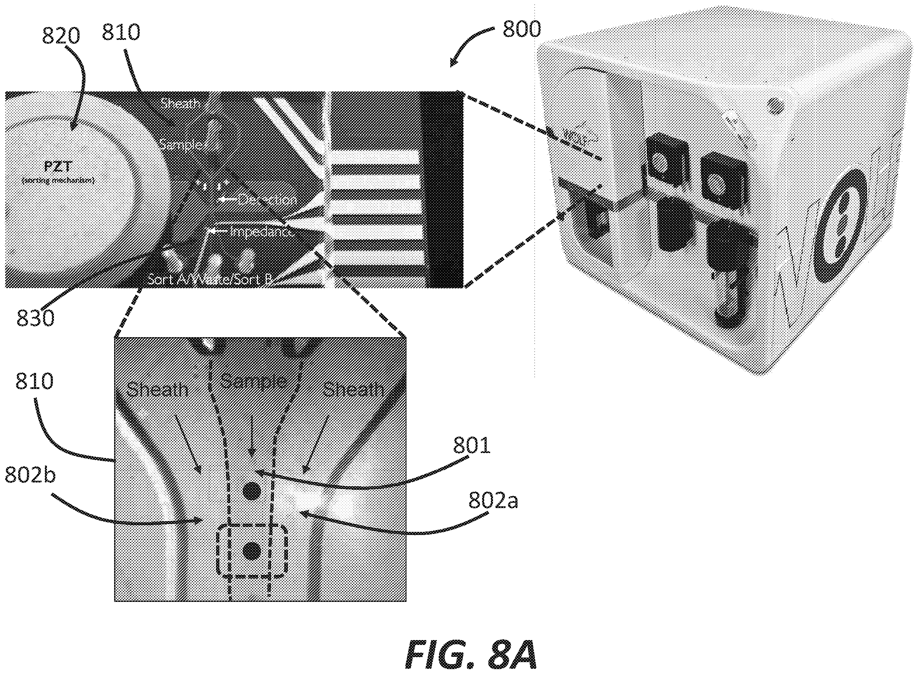

FIG. 8A shows an example flow cytometer 800 where gas dampers described herein can be employed to stabilize flow rates, such as of sample and sheath fluids. The flow cytometer 800 includes a sorting chamber 810, where sample fluid 801 including cells of interest is sandwiched between two streams of sheath fluid 802a and 802b. Pressure ratio from the two streams of sheath fluid 820a and 802b and the sample fluid 801 can be consistent and stable for proper analysis and sorting along the main channel. One factor that can influence this pressure ratio can be the flow rates of the sample and sheath fluid. To this end, peristaltic pumps in combination with gas dampers described above can be used to deliver the sample fluid 801 and sheath fluid 802a and 802b so as to achieve constant flow rates. Once a cell of interest is detected, the sorting chamber can use a piezoelectric actuator 802 to deflect the sample fluid 801 toward a designated output channel 830. More information of flow cytometers using piezoelectric sorting can be found in U.S. Patent No. 9,134,221.

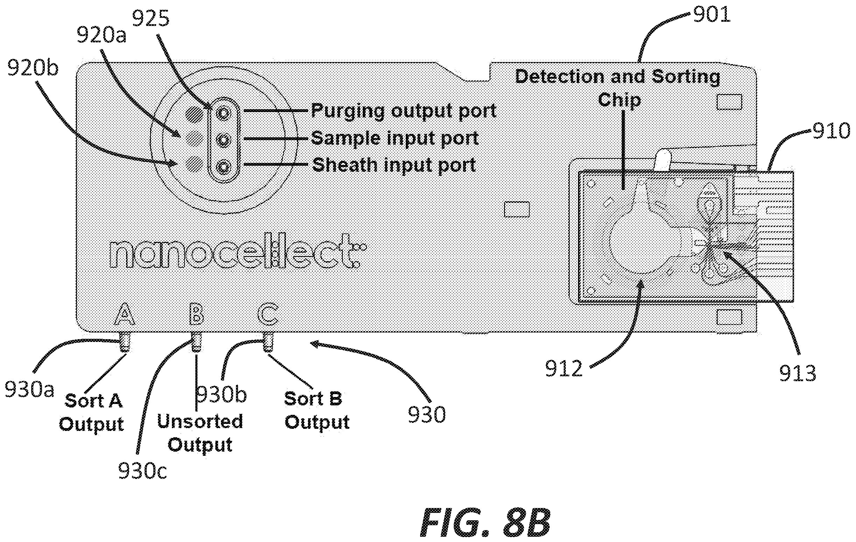

FIG. 8B illustrates an example detection and sorting chip 910 that can employ one or more dampers as described herein. An external chip 901 holds and/or is generally fluidly coupleable to the detection and sorting chip 910. In some embodiments, the detection and sorting chip 910 can be removable from the external chip 901. The detection and sorting chip 910 includes a sorting junction 913 where different cells are directed into different output channels by a piezoelectric actuator 912. In some embodiments, the piezoelectric actuator 912 can bend upward in response to a positive voltage applied on the piezoelectric actuator 912 and bend downward in response to a negative voltage applied on the piezoelectric actuator 912. By bending toward different directions, the piezoelectric actuator 912 can direct cell(s) in an input channel of the chip 910 into different output channels of the chip 910.

The external chip 901 includes a sample input port 920a to transmit sample fluid into the system 900 and a sheath input port to transmit sheath fluid into the system 900. The external chip 901 further includes a purging output port 925 to remove purging fluid after, for example, the purging fluid cleans the system 900. Three output ports 930a-930c are disposed at the edge of the external chip 901 to receive cells from the sorting junction 913 and deliver the received cells. The output ports 930 include a sort A output 930a, an unsorted output 930c, and a sort B output 930b. In some embodiments, the Sort A output 930a and Sort B output 930b receive cells from the sorting junction when the piezoelectric actuator 912 is bending upward and downward, respectively, and the unsorted output 930c can receives cells when the piezoelectric actuator 912 is in its natural state without applied voltage. Said another way, the external chip 901 can have formed therein fluidic channels (not shown) that couple the input ports 920a-920b, the purging output port 925, and the post-sorting output ports 930a-930c to respective ports of the detection and sorting chip 910. The use of a replaceable detection and sorting chip 910 can prevent sample-to-sample contamination.

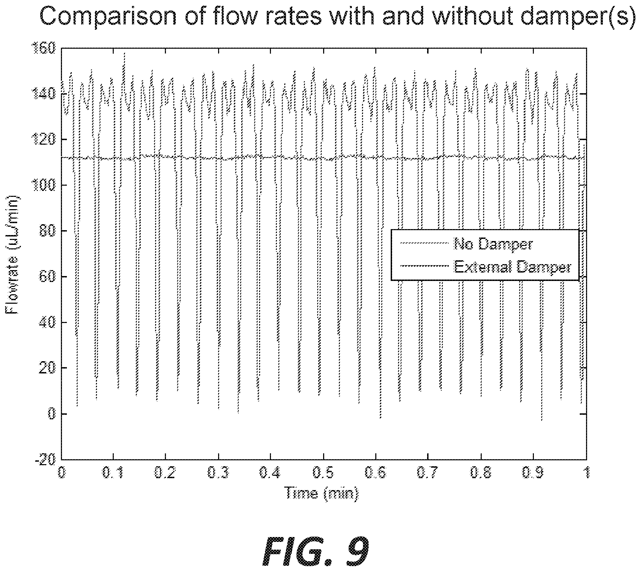

FIG. 9 illustrates measured flow rates with and without gas dampers in systems using peristaltic pumps. When the peristaltic pump tubing is directly connected to the sorting chip without a gas damper, severe pulsation ("No Damper" line) is observed with a flow rate sensor (e.g., Fluigent, Paris) placed downstream in series with the fluidic line. This flow rate pulsation ranges from 0 to over 200 µL/min. When a gas damper is connected between the pump and chip, the flow rate pulsation range drops to 110 to 113 µL/min ("External Damper" line), demonstrating significant reduction of variations of flow rates.

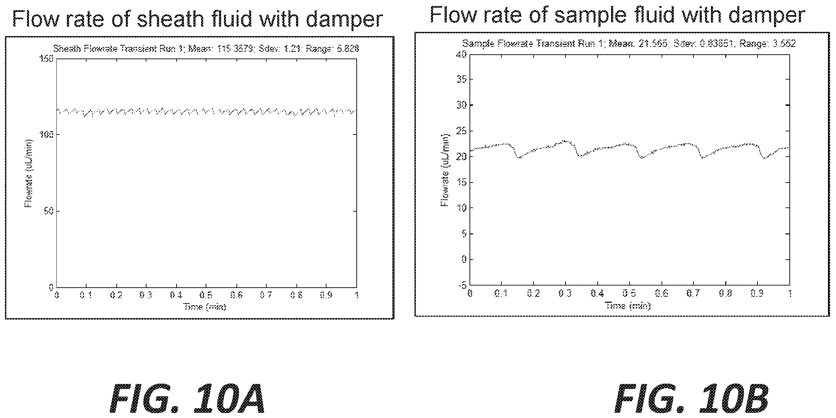

FIGS. 10A-10B are plots of flow rates versus time with external gas dampers for sample fluid and sheath fluid, respectively. Repeated analysis of both sheath fluid and sample fluid flow rates show consistent reduction of pulsation when using gas dampers. In these experiments, the average flow rate of the sheath fluid is about 120 µL/min and the average flow rate of the sample fluid is about 20 µL/min. In both cases, the resulting variations of the flow rates are less than 5 µL/min. This reduction in flow rate variation can allow cell sorting systems to use peristaltic pumps without sacrificing the performance of the sorting function.

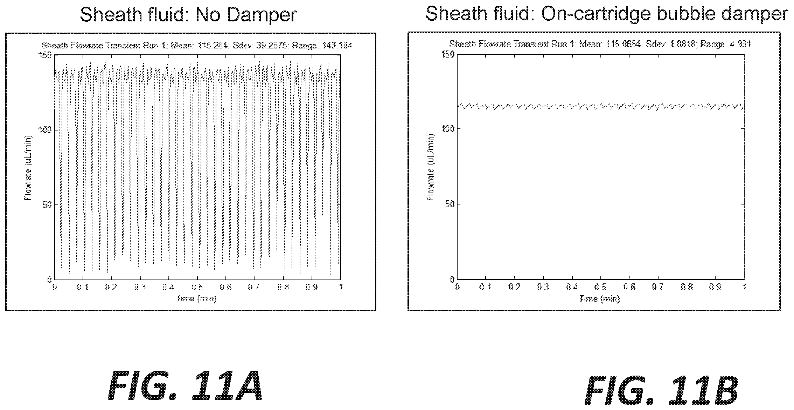

FIGS. 11A-11B are plots of flow rates versus time with and without an on-cartridge damper for sheath fluid. Without on-cartridge dampers, the flow rates of the sheath fluid after peristaltic pump are oscillating between 0 and about 145 µL/min at an oscillation frequency of about 40 cycles per minute. Including on-cartridge dampers into the system substantially stabilizes the flow rate at around 115 µL/min, with a variation less than 5 µL/min.

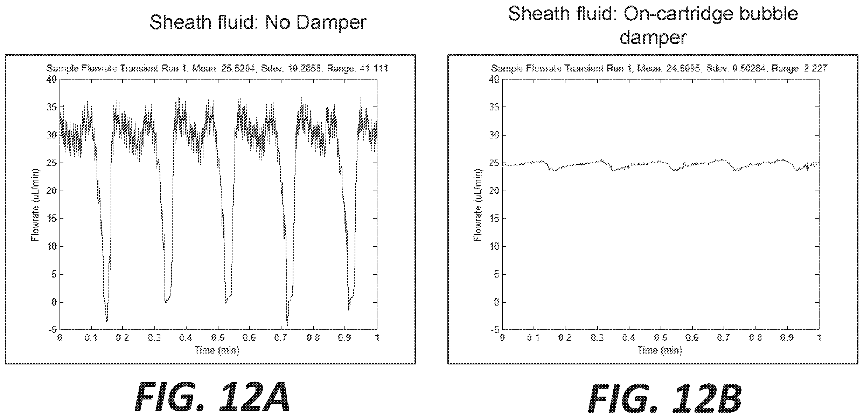

FIGS. 12A-12B are plots of flow rate versus time with and without an on-cartridge damper for sample fluid. Without on-cartridge dampers, the flow rates of the sample fluid after peristaltic pump are oscillating between 0 and about 35 µL/min at an oscillation frequency of about 6 cycles per minute. In addition, there are also some high frequency oscillations of flow rates within each cycle. Including on-cartridge dampers into the system substantially stabilizes the flow rate at around 25 µL/min, with a variation less than 3 µL/min.

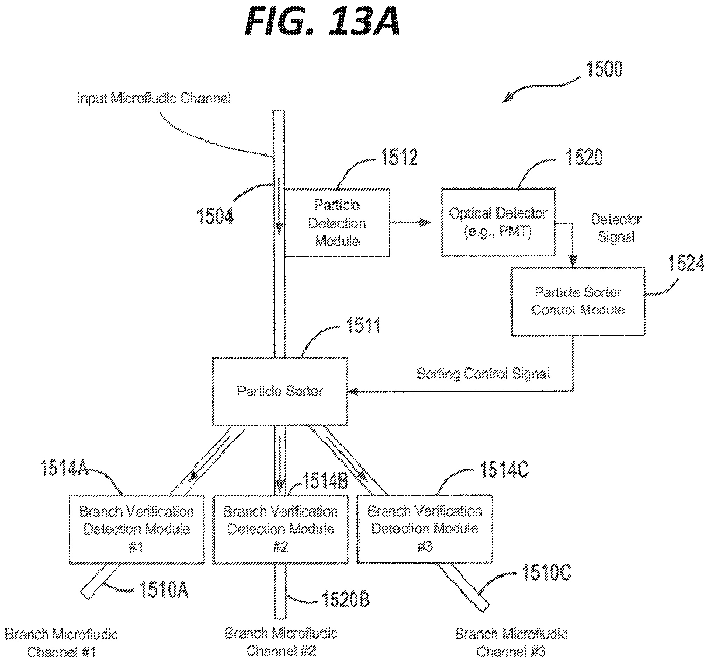

FIG. 13A illustrates an approach for verification of sorting, and illustrates a microfluidic detector/sorter 1500 (e.g., structurally and/or functionally similar to aspects of the system 100) including a sensing mechanism (e.g., reference characters 1514A-1514C, described in more detail below) in one or more branch fluidic channels 1510A-1510C downstream from a particle sorting junction 1511. In some embodiments, the combination of using the optical sensing at a pre-sorting location and sensing (e.g., optical sensing, impedance-based sensing, and/or the like) at a post-sorting location in a microfluidic detector can be used to provide better controlled operation for more efficient flow cytometry measurements. In the illustrated embodiment, the post-sorting sensing can be used to verify whether a desired particle sorting performed by the actuator in the particle sorting junction 1511 is properly executed. In the illustrated embodiment, the post-sorting sensing can be used as input for operating a post-sort valve.

In some embodiments, the embodiment of FIG. 13A includes a branch verification structure (e.g., 1514A) that is coupled to one of the branch fluidic channels (e.g., the channel 1510A) to receive light from and/or detect impedance variation in the one branch fluidic channel and to produce a branch verification optical signal that can be used to verify whether a target particle is directed by the actuator into the one branch fluidic channel. Two or more such branch verification structures can be implemented in some embodiments. In the embodiment of FIG. 13A, all three branch fluidic channels 1510A-1510C have such verification detection modules 1514A-1514C. In other embodiments, some branches can have such verification structures, when other branches may not.

In an example embodiment of FIG. 13A, the optical detector 1520 is located to receive light which includes at least the one or more optical signals from the particle detection module 1512 and the branch verification optical signal from the verification detection modules 1514A-1514C. In some embodiments, an optical detector produces a detector signal that carries information contained in the received light. The signal processing mechanism in the particle sorter control module 1524 extracts information of the branch verification optical signal to produce an indicator that verifies whether a target particle is directed by the actuator into the one branch fluidic channel. In some embodiments, irrespective of whether optical-based verification or impedance-based verification is used, the verification signal can be automatically fed back to the particle sorter control module 1524 which can, in response to a verification of malfunction in the sorting, interrupt the system operation (e.g., stopping the incoming sample flow and the sorting operation by the actuator). In some embodiments, an alert signal (e.g., a visual signal such as a pop-up warning and/or a blinking light, an audio signal such as a beep, and/or the like) can be generated by the particle sorter control module 1524 to alert the operator of a microfluidic detector of the malfunction in the sorting.

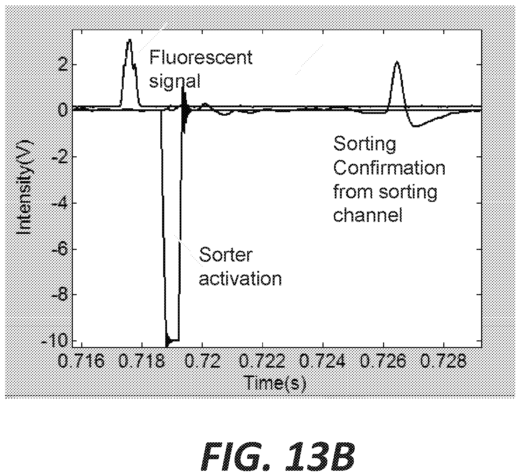

FIG. 13B is an oscilloscope trace that shows the various steps of a sorting process. First, the left-most peak in the fluorescent signal is detected optically. The negative peak moments indicates activation of the sorting actuator (e.g., a piezoelectric actuator shown in FIG. 8). The right-most peak is a post-sorting verification impedance signal as a result of successful sorting. More information about post-sorting verification using impedance signals can be found in PCT Application No. PCT/US2013/065111.

If the flow rate pulsation is too high, few correct sorting events can be observed. In addition, the speed of a particle traveling can be less consistent. Therefore, the sorting delay time, which is the time between particle detection and particle sorting actuation, is accordingly less consistent. This can result in a particle being either accelerated or decelerated, thereby decreasing the sorting efficiency, which can be defined as the ratio of the number of correct sorting events to the number of detection events. For example, if 100 cells are detected by the detection system and 50 cells are directed to the correct output channel, then the sorting efficiency is 50%. Without the dampers the sorting efficiency can be poor and varies greatly between about 0 and about 70%. Sorting performance can be noticeably improved by peristaltic pumps when gas dampers are utilized. FIG. 13 demonstrates that sorting efficiency greater than about 90%, and up to about 99%, can be achieved.

In most microfluidic systems, complete or substantially complete removal of air bubbles can be desirable since air bubbles tend to degrade signal quality and can make it hard to control the fluid due to their compressibility. To achieve stable and controllable flow status for optimal instrument performance, microfluidic chips are typically pre-filled with a liquid (a process known as "priming") so as to remove any gas bubbles in microfluidic channels. Priming a chip with liquid and removing gas bubbles prior to running a particle sample for analysis or cell sorting can be accomplished using a combination of strategically designed microfluidic channels and ports.

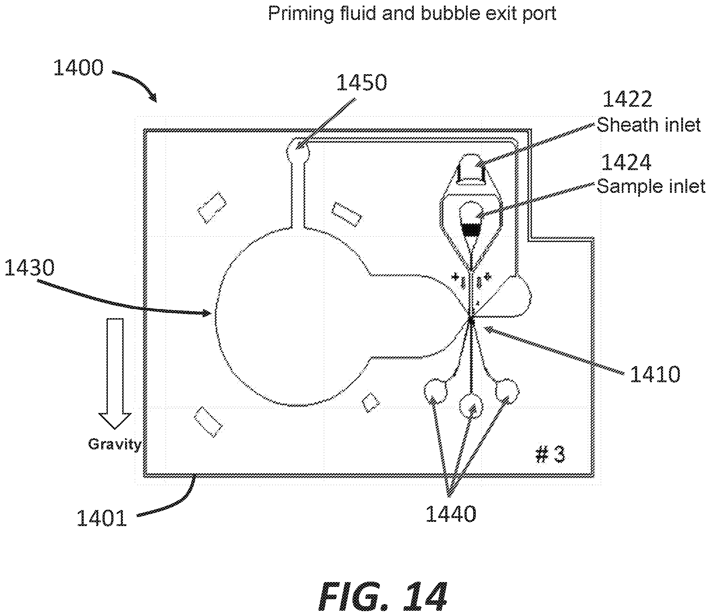

FIG. 14 shows a schematic of a microfluidics chip to illustrate methods of priming. The chip 1400 includes a substrate 1401 (or base), on which other components in the chip 1400 can be disposed. The chip 1400 includes two fluid inlets: a sheath fluid inlet 1422 to deliver sheath fluid and a sample fluid inlet 1424 to deliver sample fluid. The sheath fluid and the sample fluid are transmitted to a sorting junction 1410, where different cells in the sample fluid are directed into different output channels 1440. The sorting is carried out by a piezoelectric (PZE) actuator in a PZT chamber 1430 that can deflect the sample fluid toward different output channels 1440. In some examples, the diameter of the PZT chamber 1430 can be about 10 mm to about 30 mm (e.g., 10 mm, 15 mm, 20 mm, 25 mm, or 30 mm) and the depth of the PZT chamber 1430 can vary between 2-5 mm (e.g., 2 mm, 2.5 mm, 3 mm, 3.5 mm, 4 mm, 4.5 mm, and 5 mm). This chamber 1430 can be 1-2 orders of magnitude greater in diameter and volume than typical microfluidic chambers, which are tens to hundreds of micrometers. Due to the dimension mismatch between the microfluidic channel and the chamber and its structure, introducing liquid may not be sufficient to prime the microfluidic chip 1400 by displacing gas.

Since the chamber 1430 has meso-scale dimensions, unlike typical microfluidics, gravity can impose a larger influence on flow and filling. Therefore, mounting the chip vertically and creating a purging port 1450 on top of the PZT chamber 1430 helps to fill up the chamber completely. The PZT chamber 1430 and the liquid chamber on the opposite side can be connected via fluidic channels that vent gas, ensuring that both chambers are filled completely with liquid. The orientation and positioning of the fluidic channels and purging port 1450 allow gravity to assist in purging unwanted gas.

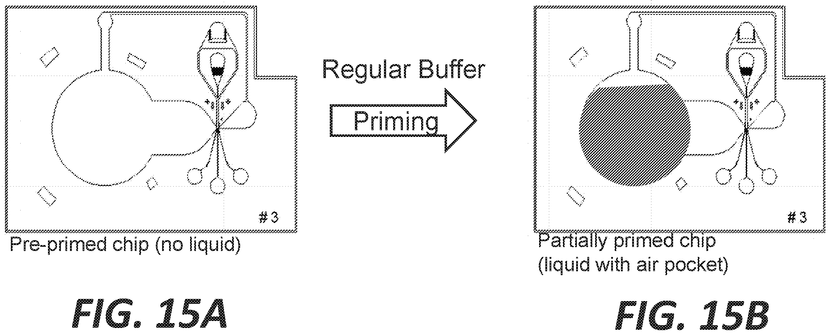

The main flow channel and the neck that connects the main flow channel to the sorting chamber can be prone to small gas bubbles mainly due to the poor wettability of most plastic materials, including PDMS, PMMA, and Cyclic Olefin Copolymer COC/ Cyclic Olefin Polymer COPs. FIGS. 15A-15B illustrate this issue. After filling regular buffer into the chip 1400, there can still be some gas in the PZE chamber 1430.

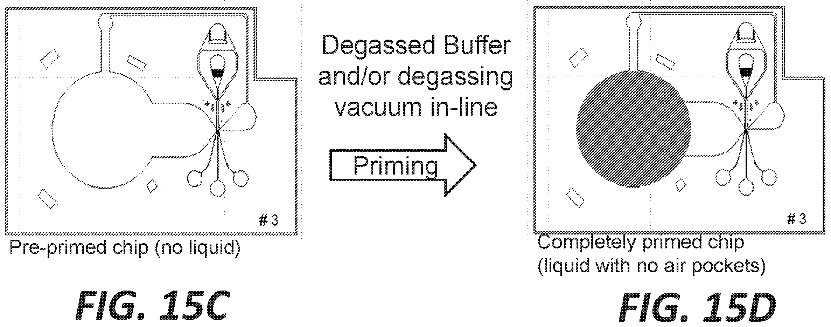

FIGS. 15C-15D illustrate methods of priming the microfluidic chip 1400 using degassed buffer. In order to remove any remaining gas bubbles after introducing fluid to fill the chambers, a degassed buffer can be loaded and a pump can direct the buffer into the chip 1400. Alternatively, the line between the pump and chip could have an "in-line" degasser. The priming liquid can be degassed before loading into the instrument or degassed using an "in-line" vacuum that can be placed in between the pump(s) and the chip. When the degassed liquid is introduced to the region of the neck between the microfluidic channel and the sorting PZT chamber, any trapped gas dissolves into the fluid and the chip is completely filled with liquid as illustrated in FIG. 15D.

Traditional particle sorting methods use a piezoelectric transducer to break the stream into droplets. Particles (e.g., cells) can be contained in some of those droplets as they break off. As droplets are formed, the droplets can be charged with positive or negative ions. The stream of droplets then passes through a pair of charged plates (e.g., charged at ± 5000 V) so that the charged droplets can be deflected and collected into test tubes/wells.

One aspect of flow sorting is, therefore, to apply a charge to the correct drops (i.e., the ones containing the desired particles) and to no others. To do this, a parameter called "time delay" or "sort delay" should be precisely adjusted. In traditional cell sorters, the time delay or sort delay is the time that it takes a particle to move from the analysis point to the point where the drop containing it breaks away from the stream. The time delay is determined by several factors including but not limited to: the distance between analysis point and sorting point, flow velocity, the generating rate of drops, the charging frequency, etc. If the time delay is not properly adjusted, the sorting purity and efficiency can be negatively affected. In addition, the user may not be able to monitor the sorting results in real time. Instead, the user has to collect and analyze the sorted sample with a cytometer to obtain the sorting information. This can be one reason why traditional cell sorters are usually operated only by well-trained technicians in a core facility.

The particle sorters as disclosed here, however, can be used to perform closed-loop particle sorting. In the system shown in FIG. 14, the time/sort delay is the time between when a particle is optically detected and when the particle reaches the sorting junction (in this case, the actuator that is triggered to deflect the particle into one of the three sorting channels). It can use scattered light and/or emitted fluorescence (detected by one or more photodetectors) as the signal to trigger sorting activation. An on-chip Piezoelectric (PZT) actuator sorts the particles by changing the flow movement transiently at the chip sorting junction. The particle sorter uses electrical methods (e.g., impedance measurements) and/or optical methods to obtain a validation signal to confirm the sorting status. In addition, a processor (electronics hardware) implements a method to adjust the timing in relation to the optical detection signal, PZT triggering signal, and validation signal to increase the sorting efficiency and monitor the sorting status in real time.

A digital sort delay can be used to compensate for any minor Y-axis alignment differences, minor manufacturing differences, or minor flow rate differences. Alignment in the Y-axis can affect proper sort timing, as the PZT sorting actuator should be activated at the exact time when the particle is in the microfluidic sorting junction following its upstream detection at the detection region. The proper sort delay can also vary from chip-to-chip due to imperfections in the microfluidic chip fabrication and variations in PZT performance. Generally, the desired sort delay for a given chip remains constant for a given flow rate.

To address fabrication imperfections and performance variations, the sorting system can define a range for sorting delay based on the distance and velocity information instead of one fixed sorting delay value. Subsequently, the system can step through this range of sort delay values. For instance, the system can step through one or sort delay values separated by as little as 1 µs per step. In some cases, the system can take large steps (e.g., 10 µs) for coarse calibration and smaller steps (e.g., 1 µs) for more precise calibration.

At each step, the system measures tens, hundreds, or thousands of particles or more to obtain the sort efficiency, which is defined as the percentage of sorting confirmation signals compared to the total number of PZT trigger events. The sorting verification signals can be electrical or optical signals measured downstream in the sorting channels. One example is to use gold electrodes downstream of fluidic channels in the microfludics chip. The electrodes are used to provide an electric field. When a particle travels across this electric field, the system measures modulation of an electrical signal (e.g., an impedance signal) caused by a particle flowing through the channel.

Once the system finishes a loop calculation of a certain distance range (for example 100 µm to 250 µm), it notifies the user of the achieved sorting efficiency. If this sorting accuracy is above an acceptable threshold, the system sets the sort delay that produced the sorting accuracy, resets the system in preparation for an actual sample run, and notifies the user that the calibration process is complete. Otherwise, the system prompts the user to repeat the calibration process with wider sorting delay range. If the desired sorting accuracy is not achieved (e.g., after three trials), the system notifies the user to replace the chip and repeat this auto calibration test.

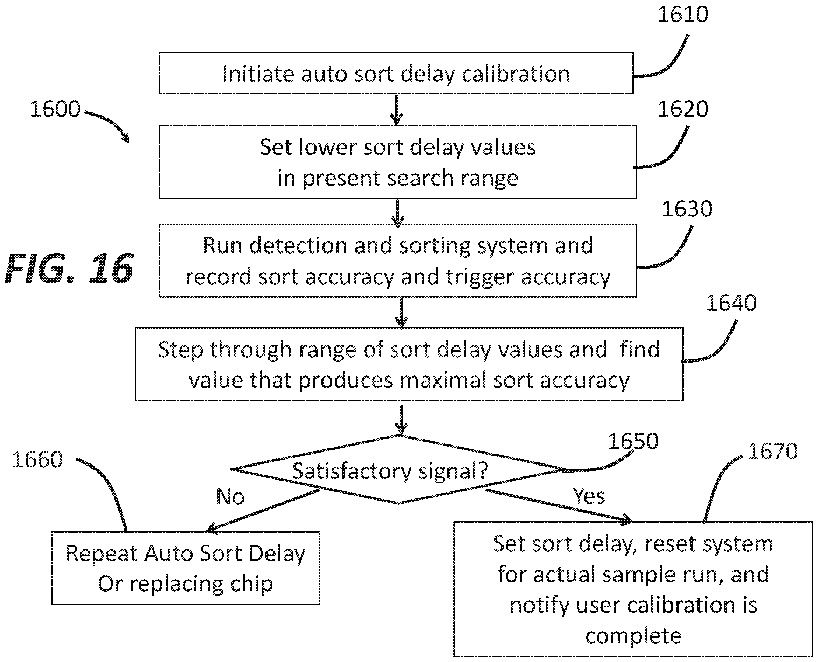

FIG. 16 illustrates a method of auto sort delay calibration described above. The method 1600 starts at step 1610 to initiate the auto sort delay calibration, followed by step 1620, at which a lower sort delay value is set in present search range. At step 1630, the detection and sorting system is operated and sort accuracy and trigger accuracy are recorded. The recorded sort accuracy and trigger accuracy can be used to find out the value of sort delay that produces the maximal sort accuracy, as in step 1640. At step 1650, the signal is examined to determine whether it is satisfactory. In response to non-satisfactory signal, the method 1600 proceeds to step 1660, where the auto sort delay is repeated or the sorting chip is replaced. On the other hand, in response to satisfactory signal at step 1650, the method 1600 proceeds to step 1670, where the sort delay producing the maximal sort accuracy is set. In addition, the system can also be set for actual sample run, thereby completing the calibration.

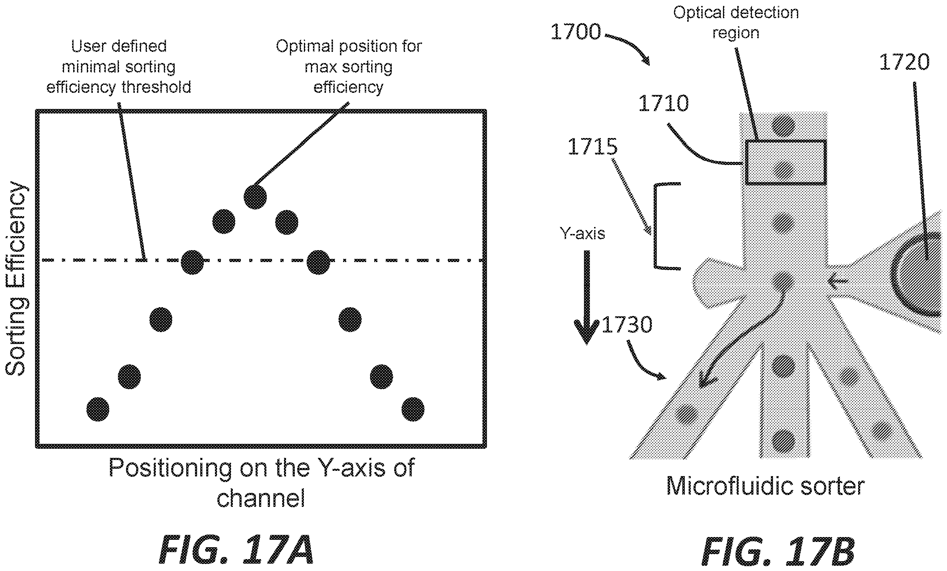

FIGS. 17A-17B illustrate optimization of particle sorting positioning and timing. FIG. 17A is a plot of sorting efficiency as a function of position on the Y-axis of the channel. FIG. 17B shows a schematic of a sorting junction 1700 including a fluid channel 1710 to propagate sample fluid and a PZT actuator 1720 to direct cells in the sample fluid toward designated output channels 1730. The fluid channel 1710 includes a region 1715, which is called Y-axis region where position is optimized to control precise timing of PZT triggering. Based on the plot shown in FIG. 17A, one can choose the position that produces the maximal sorting efficiency to set up the microfluidic chip.

While various inventive embodiments have been described and illustrated herein, those of ordinary skill in the art will readily envision a variety of other means and/or structures for performing the function and/or obtaining the results and/or one or more of the advantages described herein, and each of such variations and/or modifications is deemed to be within the scope of the inventive embodiments described herein. More generally, those skilled in the art will readily appreciate that all parameters, dimensions, materials, and configurations described herein are meant to be exemplary and that the actual parameters, dimensions, materials, and/or configurations will depend upon the specific application or applications for which the inventive teachings is/are used. Those skilled in the art will recognize, or be able to ascertain using no more than routine experimentation, many equivalents to the specific inventive embodiments described herein. It is, therefore, to be understood that the foregoing embodiments are presented by way of example only

Designing and making the technology disclosed herein may be implemented using hardware, software or a combination thereof. When implemented in software, the software code can be executed on any suitable processor or collection of processors, whether provided in a single computer or distributed among multiple computers.

Further, it should be appreciated that a computer may be embodied in any of a number of forms, such as a rack-mounted computer, a desktop computer, a laptop computer, or a tablet computer. Additionally, a computer may be embedded in a device not generally regarded as a computer but with suitable processing capabilities, including a Personal Digital Assistant (PDA), a smart phone or any other suitable portable or fixed electronic device.

Also, a computer may have one or more input and output devices. These devices can be used, among other things, to present a user interface. Examples of output devices that can be used to provide a user interface include printers or display screens for visual presentation of output and speakers or other sound generating devices for audible presentation of output. Examples of input devices that can be used for a user interface include keyboards, and pointing devices, such as mice, touch pads, and digitizing tablets. As another example, a computer may receive input information through speech recognition or in other audible format.

Such computers may be interconnected by one or more networks in any suitable form, including a local area network or a wide area network, such as an enterprise network, and intelligent network (IN) or the Internet. Such networks may be based on any suitable technology and may operate according to any suitable protocol and may include wireless networks, wired networks or fiber optic networks.

The various methods or processes (e.g., of designing and making the coupling structures and diffractive optical elements disclosed above) outlined herein may be coded as software that is executable on one or more processors that employ any one of a variety of operating systems or platforms. Additionally, such software may be written using any of a number of suitable programming languages and/or programming or scripting tools, and also may be compiled as executable machine language code or intermediate code that is executed on a framework or virtual machine.

In this respect, various inventive concepts may be embodied as a computer readable storage medium (or multiple computer readable storage media) (e.g., a computer memory, one or more floppy discs, compact discs, optical discs, magnetic tapes, flash memories, circuit configurations in Field Programmable Gate Arrays or other semiconductor devices, or other non-transitory medium or tangible computer storage medium) encoded with one or more programs that, when executed on one or more computers or other processors, perform methods that implement the various embodiments of the invention discussed above. The computer readable medium or media can be transportable, such that the program or programs stored thereon can be loaded onto one or more different computers or other processors to implement various aspects of the present invention as discussed above.

The terms "program" or "software" are used herein in a generic sense to refer to any type of computer code or set of computer-executable instructions that can be employed to program a computer or other processor. Additionally, it should be appreciated that according to one aspect, one or more computer programs that when executed perform methods of the present invention need not reside on a single computer or processor, but may be distributed in a modular fashion amongst a number of different computers or processors to implement various aspects of the present invention.

Computer-executable instructions may be in many forms, such as program modules, executed by one or more computers or other devices. Generally, program modules include routines, programs, objects, components, data structures, etc. that perform particular tasks or implement particular abstract data types. Typically the functionality of the program modules may be combined or distributed as desired.

Also, data structures may be stored in computer-readable media in any suitable form. For simplicity of illustration, data structures may be shown to have fields that are related through location in the data structure. Such relationships may likewise be achieved by assigning storage for the fields with locations in a computer-readable medium that convey relationship between the fields. However, any suitable mechanism may be used to establish a relationship between information in fields of a data structure, including through the use of pointers, tags or other mechanisms that establish relationship between data elements.

## Claims

1. A system (600), comprising:
a microfluidic channel in fluid communication with a sorting chamber (710), a sheath fluid channel (610), and a sample fluid channel (720);
a sample fluid pump (525) in fluid communication with the sample fluid channel (720), the sample fluid pump (525) configured to pump sample fluid through the sample fluid channel (720) to the sorting chamber (710) at a sample fluid flow rate;
a sheath peristaltic pump (535) in fluid communication with the sheath fluid channel (610), the sheath peristaltic pump (535) configured to pump a fluid through the sheath fluid channel (610) at a sheath fluid flow rate; and
a sheath fluid damper (620) including a gas and in fluid communication with the sheath fluid channel (610), the sheath fluid damper (620) configured to reduce variations in the sheath fluid flow rate by compression and expansion of the gas in response to fluid flow in the sheath fluid channel (610).

2. The system of claim 1, further including a disposable substrate (601) defining at least a portion of the sorting chamber (710) and the sheath fluid channel (610).

3. The system of claim 2, wherein at least a portion of the sheath fluid damper (620) is formed on the disposable substrate (601).

4. The system of claim 2, wherein the disposable substrate (601) includes silicone.

5. The system of claim 1, wherein the reduced variations of the sheath fluid flow rate are less than about 10% of an average flow rate.

6. The system of claim 1, wherein the sheath fluid flow rate is from 1 µl/min to 1 ml/min.

7. The system of claim 1, wherein the sheath fluid damper (620) includes at least one of a rectangular gas chamber, a cylindrical gas chamber, an oval gas chamber, and a round gas chamber.

8. The system of claim 1, wherein the sheath fluid damper (620) includes at least two gas chambers disposed in series along the sheath fluid channel (610).

9. The system of claim 1, wherein the sheath fluid damper (620) has a volume of from 60 mm³ to 600 mm³.

10. The system of claim 1, wherein the sheath fluid damper (620) is configured to reduce the variations of the sample fluid flow rate by more than 95%.

11. The system of claim 1, wherein the sample fluid pump (525) comprises a sample fluid peristaltic pump.

12. The system of claim 1, wherein the sorting chamber (710) has a diameter of from about 10 mm to about 30 mm and a depth of from about 2 mm to about 5 mm.

13. The system of claim 11, further comprising a sample fluid damper (728) comprising a second gas and in fluid communication with the sample fluid channel (720), the sample fluid damper (728) configured to reduce variations in the sample fluid flow rate by compression and expansion of the second gas in response to fluid flow in the sample fluid channel (720).

14. The system of claim 1, further comprising a cartridge (901), the cartridge (901) including the sheath fluid damper (620).

15. The system of claim 14, further comprising a sorting chip (510) coupleable to the cartridge (901), the sorting chip (510) including the sorting chamber (710).

## Patentansprüche

1. Ein System (600), umfassend:
Einen mikrofluidischen Kanal in Fluidverbindung mit einer Sortierkammer (710), einen Hüllflüssigkeitskanal (610) und einen Probenflüssigkeitskanal (720);
eine Probenflüssigkeitspumpe (525) in Fluidverbindung mit dem Probenflüssigkeitskanal (720), die Probenflüssigkeitspumpe (525) ist dabei so konfiguriert, dass sie Probenflüssigkeit durch den Probenflüssigkeitskanal (720) in die Sortierkammer (710) in einer Probenflüssigkeits-Durchflussrate pumpt;
eine Hüll-Peristaltikpumpe (535) in Fluidverbindung mit dem Hüllflüssigkeitskanal (610), die Hüllflüssigkeitspumpe (535) ist dabei so konfiguriert, dass sie eine Flüssigkeit durch den Hüllflüssigkeitskanal (610) in einer Hüllflüssigkeits-Durchflussrate pumpt; und
einen Hüllflüssigkeitsdämpfer (620), der ein Gas beinhaltet und in Fluidverbindung mit dem Hüllflüssigkeitskanal (610) steht, der Hüllflüssigkeitsdämpfer (620) ist so konfiguriert, dass er die Schwankungen in der Hüllflüssigkeits-Durchflussrate durch Kompression und Expansion des Gases, als Reaktion auf den Flüssigkeitsdurchfluss im Hüllflüssigkeitskanal (610), reduziert.

2. System nach Anspruch 1, das ferner ein Einwegsubstrat (601) beinhaltet, das mindestens einen Abschnitt der Sortierkammer (710) und des Hüllflüssigkeitskanals (610) definiert.

3. System nach Anspruch 2, wobei mindestens ein Abschnitt des Hüllflüssigkeitsdämpfers (620) auf dem Einwegsubstrat (601) gebildet wird.

4. System nach Anspruch 2, wobei das Einwegsubstrat (601) Silikon beinhaltet.

5. System nach Anspruch 1, wobei die reduzierten Schwankungen der Hüllflüssigkeits-Durchflussrate geringer sind als ungefähr 10 % der durchschnittlichen Durchflussrate.

6. System nach Anspruch 1, wobei die Hüllflüssigkeits-Durchflussrate von 1 µl/min bis 1 ml/min beträgt.

7. System nach Anspruch 1, wobei der Hüllflüssigkeitsdämpfer (620) mindestens entweder eine rechtwinklige Gaskammer, eine zylindrische Gaskammer, eine ovale Gaskammer oder eine runde Gaskammer beinhaltet.

8. System nach Anspruch 1, wobei der Hüllflüssigkeitsdämpfer (620) mindestens zwei Gaskammern beinhaltet, die in Reihe entlang des Hüllflüssigkeitskanals (610) angeordnet sind.

9. System nach Anspruch 1, wobei der Hüllflüssigkeitsdämpfer (620) ein Volumen von 60 mm³ bis 600 mm³ aufweist.

10. System nach Anspruch 1, wobei der Hüllflüssigkeitsdämpfer (620) so konfiguriert ist, dass er die Schwankungen der Probenflüssigkeits-Durchflussrate um mehr als 95 % reduziert.

11. System nach Anspruch 1, wobei die Probenflüssigkeitspumpe (525) eine Probenflüssigkeits-Peristaltikpumpe umfasst.

12. System nach Anspruch 1, wobei die Sortierkammer (710) einen Durchmesser von ungefähr 10 mm bis ungefähr 30 mm und eine Tiefe von ungefähr 2 mm bis ungefähr 5 mm aufweist.

13. System nach Anspruch 11, ferner umfassend einen Probenflüssigkeitsdämpfer (728), der ein zweites Gas umfasst und in Fluidverbindung mit dem Probenflüssigkeitskanal (720) steht, der Probenflüssigkeitsdämpfer (728) ist so konfiguriert, dass er die Schwankungen in der Probenflüssigkeits-Durchflussrate durch Kompression und Expansion des zweiten Gases, als Reaktion auf den Flüssigkeitsdurchfluss im Probenflüssigkeitskanal (720), reduziert.

14. System nach Anspruch 1, ferner umfassend eine Kartusche (901), wobei die Kartusche (901) den Hüllflüssigkeitsdämpfer (620) beinhaltet.

15. System nach Anspruch 14, ferner umfassend einen Sortierchip (510), der mit der Kartusche (901) koppelbar ist, wobei der Sortierchip (510) die Sortierkammer (710) beinhaltet.

## Revendications

1. Système (600) comprenant :
un canal microfluidique en communication fluidique avec une chambre de tri (710), un canal de fluide de gaine (610) et un canal de fluide d'échantillon (720) ;
une pompe de fluide d'échantillon (525) en communication fluidique avec le canal de fluide d'échantillon (720), la pompe de fluide d'échantillon (525) étant conçue pour pomper l'échantillon de fluide à travers le canal de fluide d'échantillon (720) vers la chambre de tri (710) à un débit de fluide d'échantillon ;
une pompe péristaltique de gaine (535) en communication fluidique avec le canal de fluide de gaine (610), la pompe péristaltique de gaine (535) étant conçue pour pomper un fluide à travers le canal de fluide de gaine (610) à un débit de fluide de gaine ; et
un amortisseur de fluide de gaine (620) comportant un gaz et en communication fluidique avec le canal de fluide de gaine (610), l'amortisseur de fluide de gaine (620) est conçu pour réduire les variations du débit de fluide de gaine par compression et expansion du gaz en réponse à l'écoulement de fluide dans le canal de fluide de gaine (610).

2. Système selon la revendication 1, comportant en outre un substrat jetable (601) définissant au moins une partie de la chambre de tri (710) et du canal de fluide de gaine (610).

3. Système selon la revendication 2, dans lequel au moins une partie de l'amortisseur de fluide de gaine (620) est formée sur le substrat jetable (601).

4. Système selon la revendication 2, dans lequel le substrat jetable (601) comporte du silicone :

5. Système selon la revendication 1, dans lequel les variations réduites du débit de fluide de gaine sont inférieures à environ 10 % d'un débit moyen.

6. Système selon la revendication 1, dans lequel le débit de fluide de gaine va de 1 µl/min à 1 ml/min

7. Système selon la revendication 1, dans lequel l'amortisseur de fluide de gaine (620) comporte au moins une chambre parmi une chambre à gaz rectangulaire, une chambre à gaz cylindrique, une chambre à gaz ovale et une chambre à gaz ronde.

8. Système selon la revendication 1, dans lequel l'amortisseur de fluide de gaine (620) comporte au moins deux chambres à gaz disposées en série le long du canal de fluide de gaine (610).

9. Système selon la revendication 1, dans lequel l'amortisseur de fluide de gaine (620) présente un volume allant de 60 mm³ à 600 mm³.

10. Système selon la revendication 1, dans lequel l'amortisseur de fluide de gaine (620) est conçu pour réduire les variations du débit de fluide d'échantillon de plus de 95 %.

11. Système selon la revendication 1, dans lequel la pompe de fluide d'échantillon (525) comprend une pompe péristaltique de fluide d'échantillon.

12. Système selon la revendication 1, dans lequel la chambre de tri (710) présente un diamètre allant d'environ 10 mm à environ 30 mm et une profondeur allant d'environ 2 mm à environ 5 mm.

13. Système selon la revendication 11, comprenant en outre un amortisseur de fluide d'échantillon (728) comprenant un second gaz et en communication fluidique avec le canal de fluide d'échantillon (720), l'amortisseur de fluide d'échantillon (728) est conçu pour réduire les variations du débit de fluide d'échantillon par compression et expansion du second gaz en réponse à l'écoulement de fluide dans le canal de fluide d'échantillon (720).

14. Système selon la revendication 1, comprenant en outre une cartouche (901), la cartouche (901) comportant l'amortisseur de fluide de gaine (620).

15. Système selon la revendication 14, comprenant en outre une puce de tri (510) pouvant être couplée à la cartouche (901), la puce de tri (510) comportant la chambre de tri (710).
